# DEMANDE DE BREVET EUROPEEN

(11) **EP 4 818 819 A1**
(43) Date de publication de la demande: **07.10.2026**
(21) Numéro de dépôt: 25168513.7
(22) Date de dépôt: 04.04.2025
(51) Int. Cl.: G04B 15/14, G04B 17/06, G04B 19/04, B81C 1/00

(54) **PROCÉDÉ DE FABRICATION DE COMPOSANTS HORLOGERS EN SILICIUM**

(71) Demandeur: PATEK PHILIPPE SA GENEVE, 1204 Genève (CH)
(72) Inventeur: FOURNIER, Rémy, 1228 Plan-les-Ouates (CH)
(74) Mandataire: Micheli & Cie SA

(57) **Abrégé**

Un procédé de fabrication de composants horlogers selon un premier mode de réalisation de l'invention comprend les étapes suivantes : se munir d'une plaquette (10) comprenant une couche de silicium (11) ; former une couche de parylène (13) au moins sur un premier côté de la plaquette ; graver la couche de silicium (11) par gravure ionique réactive depuis un deuxième côté de la plaquette opposé au premier côté, de sorte à former dans la couche de silicium (11) un squelette (16), des composants horlogers (15), des attaches (17) reliant les composants horlogers (15) au squelette (16) et des parties sacrificielles (18, 19), les parties sacrificielles (18, 19) n'étant reliées ni au squelette (16) ni aux composants horlogers (15) dans la couche de silicium (11) gravée mais étant maintenues dans la plaquette par la couche de parylène (13) ; éliminer la couche de parylène (13) ; rompre ou éliminer les attaches (17). Un mode de réalisation est aussi proposé pour la fabrication de composants horlogers à partir d'une plaquette de type silicium sur isolant. D'autres modes de réalisation concernent la fabrication de composants horlogers sans formation d'attaches entre les composants et le reste de la plaquette.

## Description

La présente invention concerne la fabrication de composants horlogers en silicium.

Des procédés de fabrication de composants horlogers en silicium ont été décrits notamment dans les demandes de brevet WO 2019/180596 et WO 2021/224804 du présent déposant. Ils utilisent la gravure ionique réactive, technique connue sous l'abréviation anglaise RIE, plus précisément la gravure ionique réactive profonde (DRIE), pour graver des composants horlogers dans une couche de silicium d'une plaquette à travers un masque de résine photosensible obtenu par photolithographie. Pendant la gravure sont formées des attaches reliant les composants horlogers au reste de la plaquette. Ces attaches sont rompues seulement à la fin du procédé, après application de différents traitements aux composants horlogers. La demande de brevet WO 2021/224804 mentionne en outre la possibilité de former lors de la gravure du silicium des parties sacrificielles qu'aucune attache ne relie au reste de la plaquette dans la couche de silicium. De telles parties sacrificielles, une fois enlevées, forment des évidements de tailles diverses dans et autour des composants horlogers. Ces évidements sont ainsi obtenus uniquement par la gravure des pourtours des parties sacrificielles suivie de l'enlèvement de ces dernières. Cette technique permet de s'affranchir du défaut connu sous le nom de « RIE lag » selon lequel la vitesse de la gravure ionique réactive dépend de la taille des ouvertures du masque, et donc d'obtenir une vitesse de gravure uniforme sur toute la plaquette.

Cependant, par définition, les parties sacrificielles sont destinées à être libérées de la plaquette à un moment ou à un autre pendant le procédé. Si l'on réalise des parties sacrificielles dans une plaquette dite simple comprenant une unique couche de silicium, ces parties sacrificielles tomberont dans la machine de gravure à la fin de la gravure ionique réactive du silicium, ce qui nécessitera un nettoyage de la machine de gravure. Le même problème se pose avec la gravure ionique réactive des deux côtés d'une plaquette de type silicium sur isolant (pour la réalisation de composants horlogers à deux niveaux), puisque la couche intermédiaire de dioxyde de silicium de ce type de plaquette n'est généralement pas suffisamment résistante pour maintenir les parties sacrificielles. Or, l'intérieur des machines de gravure RIE/DRIE est soumis à un vide poussé, de l'ordre de 10⁻⁶ mbar, qui rend fastidieux son nettoyage. L'intérieur de la machine doit en effet d'abord être ventilé pour ramener sa pression à la valeur de la pression atmosphérique et sa température à la valeur de la température ambiante. Après le nettoyage, les joints doivent être graissés, la machine refermée et le vide regénéré. Le tout prend généralement plusieurs heures.

On peut aussi souhaiter réaliser des composants horlogers dépourvus de tout résidu d'attache, notamment lorsque les composants doivent présenter un aspect particulièrement soigné, comme par exemple dans le cas des aiguilles indicatrices, ou lorsque les résidus d'attache risqueraient de perturber la fonction des composants, comme par exemple dans le cas de certaines roues dentées. Il est alors préférable de ne pas former d'attaches reliant les composants horlogers au reste de la plaquette pendant la gravure. A l'instar des parties sacrificielles susmentionnées, les composants horlogers resteront donc dans la machine de gravure lors du retrait de la plaquette après la gravure ionique réactive du silicium, nécessitant une opération compliquée pour les recueillir.

Une solution existe pour maintenir dans la plaquette les parties sacrificielles ou composants horlogers sans attaches après la gravure ionique réactive. Elle consiste à appliquer préalablement un ruban adhésif au dos de la plaquette. Cette solution n'est toutefois pas satisfaisante pour au moins deux raisons. La première raison est que si une bulle d'air est laissée entre le ruban adhésif et la plaquette, elle pourra brûler toute une partie de la plaquette pendant la gravure ionique réactive. La deuxième raison est que pour enlever le ruban adhésif après la gravure ionique réactive, la plaquette doit être trempée dans un bain de solvant avec le risque de polluer les composants horlogers.

La présente invention vise à remédier, au moins en partie, aux inconvénients susmentionnés et propose à cet effet un procédé de fabrication de composants horlogers selon la revendication 1, la revendication 3, la revendication 6 ou la revendication 8.

D'autres caractéristiques et avantages de la présente invention apparaîtront à la lecture de la description détaillée suivante faite en référence aux dessins schématiques annexés dans lesquels :
- les figures 1a à 1h montrent par des vues en section des étapes successives d'un procédé de fabrication de composants horlogers selon un premier mode de réalisation de l'invention ;
- la figure 2 est une vue de dessus d'une roue d'échappement gravée dans une plaquette de silicium et reliée par une attache au reste de la plaquette, avec des parties sacrificielles gravées à l'intérieur et à l'extérieur de la roue d'échappement ;
- la figure 3 est une vue en section montrant une étape d'une variante du procédé de fabrication de composants horlogers selon le premier mode de réalisation de l'invention ;
- les figures 4a à 4i montrent par des vues en section des étapes successives d'un procédé de fabrication de composants horlogers selon un deuxième mode de réalisation de l'invention ;
- la figure 5 est une vue en section montrant une étape d'une variante du procédé de fabrication de composants horlogers selon le deuxième mode de réalisation de l'invention.

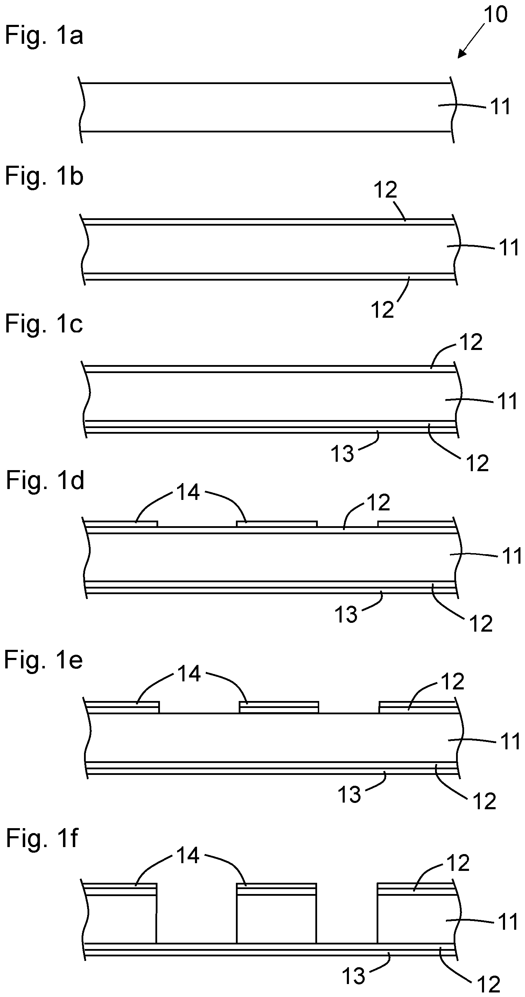

En référence aux figures 1a à 1h, un procédé de fabrication de composants horlogers selon un premier mode de réalisation de l'invention comprend une première étape consistant à se munir d'une plaquette (« wafer ») 10 en silicium, plus précisément d'une plaquette simple constituée d'une unique couche de silicium 11 (figure 1a). Le silicium peut être monocristallin - quelle que soit son orientation cristalline -, polycristallin ou amorphe. Il peut être dopé ou non.

Dans une deuxième étape du procédé (figure 1b), une couche de dioxyde de silicium 12 est formée au moins sur les surfaces supérieure et inférieure de la plaquette 10. La couche de dioxyde de silicium 12 peut être déposée sur la plaquette, par exemple par dépôt chimique ou physique en phase vapeur (CVD, PVD), ou peut être obtenue par oxydation thermique de la plaquette dans un four à haute température (typiquement entre 800°C et 1200°C) sous atmosphère humide. Dans le cas de l'oxydation thermique, toutes les surfaces de la plaquette sont couvertes par la couche de dioxyde de silicium.

Dans une troisième étape (figure 1c), une couche de parylène 13 est formée, par exemple par dépôt sous vide, sur la surface inférieure de la plaquette 11, 12 obtenue à l'issue de la deuxième étape. Pendant la formation de cette couche de parylène, la surface supérieure de la plaquette 11, 12 peut être protégée par un masque. De préférence, toutefois, la couche de parylène 13 est formée de manière uniforme sur toutes les surfaces de la plaquette 11, 12 puis elle est retirée sur la surface supérieure. Le parylène peut en effet être facilement éliminé sur une surface donnée, par exemple par gravure ionique réactive (RIE), et typiquement par une gravure RIE utilisant de l'oxygène comme gaz réactif.

Dans une quatrième étape (figure 1d), on forme de manière classique un masque de résine photosensible 14 sur la surface supérieure de la plaquette 11, 12, 13 obtenue à l'issue de la troisième étape, par dépôt d'une couche de résine photosensible puis structuration de cette couche par photolithographie.

Dans une cinquième étape (figure 1e), la couche de dioxyde de silicium 12 du côté supérieur de la plaquette 11, 12, 13 est gravée à travers les ouvertures du masque de résine photosensible 14, par exemple par gravure RIE, typiquement par une gravure RIE utilisant comme gaz réactif le trifluorométhane (CHF₃). La couche de dioxyde de silicium ainsi gravée constitue elle aussi un masque de gravure.

Une sixième étape (figure 1f) consiste à graver la couche de silicium 11 à travers les ouvertures de la superposition des masques de résine photosensible 14 et de dioxyde de silicium 12 par gravure ionique réactive RIE, de préférence par la technique de gravure ionique réactive profonde connue sous l'abréviation anglaise DRIE. La gravure ionique réactive profonde met en œuvre une alternance de phases de gravure et de phases de passivation. Des exemples typiques de gaz pouvant être utilisés pour les phases de gravure et de passivation sont l'hexafluorure de soufre (SF₆) et l'octafluorocyclobutane (C₄F₈) respectivement. La gravure de la couche de silicium 11 est arrêtée par la couche de dioxyde de silicium 12 présente du côté inférieur de la plaquette. Pendant la gravure du silicium, le masque de résine photosensible 14 est progressivement détruit (à une vitesse très inférieure à la vitesse de gravure du silicium) par le plasma de la gravure RIE/DRIE. Le masque de dioxyde de silicium formé du côté supérieur de la plaquette permet de compléter l'action du masque de résine photosensible 14, en prenant le relais de ce dernier après sa destruction. Le masque de dioxyde de silicium est ainsi particulièrement utile dans le cas où l'épaisseur de la couche de silicium 11 est grande.

La couche de silicium 11 gravée comprend un squelette, des composants horlogers, des attaches ou ponts de matière reliant les composants horlogers au squelette (une ou plusieurs attaches par composant horloger) et des parties sacrificielles. Les parties sacrificielles sont situées à l'intérieur et/ou à l'extérieur des composants horlogers. Chacune d'entre elles est entourée, et séparée du reste de la couche de silicium 11, par une rainure qui traverse toute l'épaisseur de la couche de silicium 11. Les parties sacrificielles ne sont ainsi reliées au reste de la couche de silicium 11 par aucune attache et elles ne sont tenues que par la couche de dioxyde de silicium 12 et la couche de parylène 13.

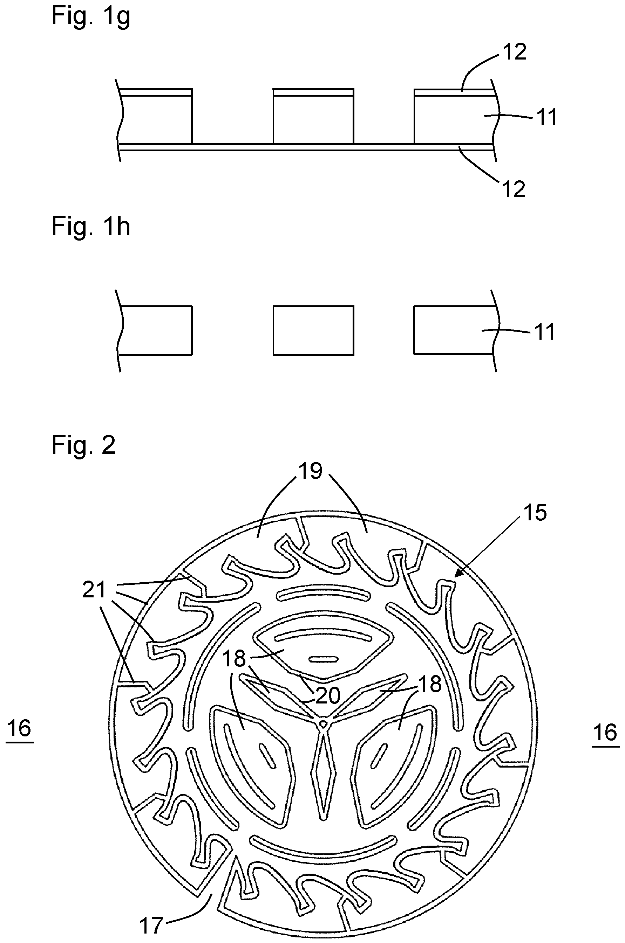

A titre d'exemple, la figure 2 montre une roue d'échappement 15 reliée à un squelette 16 par une attache 17, et des parties sacrificielles 18, 19 délimitées par des rainures traversantes 20, 21 à l'intérieur et à l'extérieur de la roue d'échappement. Les parties sacrificielles 18 à l'intérieur de la roue d'échappement et les rainures 20 qui les entourent sont destinées, une fois les parties sacrificielles 18 enlevées, à former des évidements traversants dans la roue d'échappement 15 pour par exemple définir des bras élastiques permettant le montage de la roue d'échappement sur un axe et/ou absorber des contraintes de déformation et/ou alléger la roue d'échappement. Les parties sacrificielles 19 à l'extérieur de la roue d'échappement 15 et les rainures 21 qui les entourent sont destinées à former ensemble un évidement traversant entourant la roue d'échappement 15 et la séparant donc du squelette 16, évidement que traversera l'attache 17.

La réalisation de parties sacrificielles, plutôt que la gravure entière d'évidements, permet notamment de simplifier et d'homogénéiser la gravure. En effet, les composants horlogers, les attaches et les parties sacrificielles peuvent être formés par la gravure de rainures uniquement, ayant toutes la même largeur, et dans lesquelles pénètre le plasma avec la même densité chimique d'une rainure à l'autre. Si les évidements étaient entièrement gravés, la densité chimique du plasma varierait en fonction de la taille de l'évidement, ce qui conduirait à des gravures plus rapides à travers les ouvertures du masque les plus grandes (phénomène appelé « RIE lag »). Une gravure plus rapide, ou surgravure, d'un évidement par rapport à un autre ferait que les ions du plasma arriveraient plus rapidement au contact de la couche de dioxyde de silicium 12 dans l'évidement le plus grand. Ces ions du plasma rebondissant sur la couche de dioxyde de silicium 12 pourraient se rediriger vers les flancs de l'évidement et dégrader leur état de surface ainsi que leur verticalité. A noter que ce phénomène de rebond se produirait aussi en l'absence de couches de dioxyde de silicium et de parylène sur la plaquette, lorsque les ions arriveraient au contact du support sur lequel est posée la plaquette pendant la gravure RIE/DRIE du silicium. Un tel support, généralement en céramique, est en effet utilisé pendant les gravures RIE et DRIE pour refroidir la plaquette.

La couche de parylène 13 a pour fonction de maintenir les parties sacrificielles dans la plaquette avec les composants horlogers de sorte qu'elles ne restent pas dans la machine de gravure RIE/DRIE lorsque l'on retire de ladite machine la plaquette gravée à la fin de la sixième étape. La chute de parties sacrificielles nécessiterait en effet de nettoyer la machine de gravure, opération longue et délicate compte tenu du vide poussé (vide dit secondaire) qui y règne, généralement de l'ordre de 10⁻⁶ mbar. La couche de dioxyde de silicium 12 n'est pas suffisante pour garantir le maintien des parties sacrificielles. Dans les zones où le silicium a été retiré, la couche de dioxyde de silicium 12 subit un stress compressif qui la rend très fragile et donc susceptible de céder sous le poids des parties sacrificielles. Le parylène, lui, présente une bonne résistance mécanique. En outre, comme déjà indiqué, il est facile à éliminer.

Une septième étape du procédé (figure 1g) consiste à éliminer, sur la plaquette 11, 12, 13, 14 obtenue à la fin de la sixième étape, les matières carbonées, à savoir les résidus du masque de résine photosensible 14, la couche de parylène 13 et les couches de passivation, par exemple par décapage au plasma d'oxygène (en anglais : oxygen plasma stripping). Les machines de décapage au plasma fonctionnent sous un vide moyen (vide dit primaire), généralement de l'ordre de 10⁻² mbar. Par conséquent, si des parties sacrificielles tombent pendant cette étape en faisant céder la couche de dioxyde de silicium, elles peuvent ensuite être retirées de la machine assez facilement. Le nettoyage d'une machine de décapage au plasma prend seulement quelques minutes, contre plusieurs heures pour une machine de gravure RIE/DRIE.

Dans une huitième étape (figure 1h), la couche de dioxyde de silicium 12 est éliminée par exemple par gravure chimique humide ou gravure chimique en phase vapeur, typiquement à l'acide fluorhydrique (HF). Les parties sacrificielles encore solidaires du squelette à la fin de la septième étape tombent. A la fin de la huitième étape, la plaquette ne comprend plus que le squelette et les composants horlogers entourés et séparés du squelette par des évidements traversants et reliés au squelette par des attaches s'étendant à travers lesdits évidements traversants, le tout uniquement en silicium. Les parties sacrificielles libérées de la plaquette sont là aussi faciles à retirer. Elles peuvent en effet être recueillies dans un panier préalablement placé dans le bain d'acide fluorhydrique ou dans un filet préalablement placé dans la machine de gravure chimique en phase vapeur.

Enfin, dans une neuvième étape, les composants horlogers sont détachés du squelette par rupture ou élimination des attaches, par exemple au moyen d'un laser.

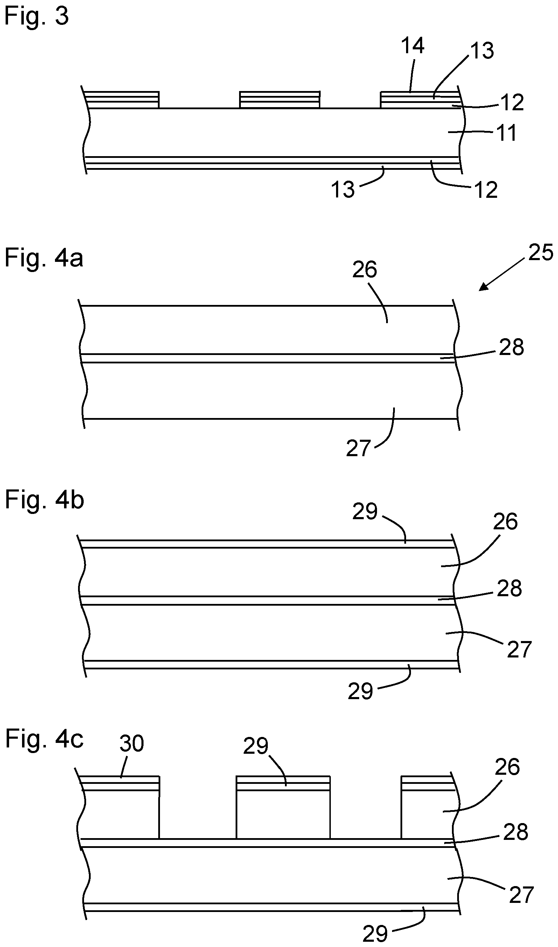

Selon une variante du premier mode de réalisation de l'invention, dans la troisième étape, la couche de parylène 13 formée sur toutes les surfaces de la plaquette n'est pas retirée sur la surface supérieure de la plaquette. Ainsi, entre les quatrième et cinquième étapes, la couche de parylène du côté supérieur de la plaquette est gravée, par exemple par une gravure RIE utilisant de l'oxygène comme gaz réactif, pour y former des ouvertures alignées avec les ouvertures du masque de résine photosensible 14. Le masque pour la gravure de la couche de silicium 11 à la sixième étape est alors constitué par la superposition des couches gravées de résine photosensible 14, de parylène 13 et de dioxyde de silicium 12, comme illustré à la figure 3. Laisser la couche de parylène 13 tout autour de la plaquette dans la troisième étape supprime le risque que le solvant utilisé pour développer la résine photosensible dans la quatrième étape s'introduise entre les couches de dioxyde de silicium 12 et de parylène 13 et provoque un décollement de la couche de parylène 13 du côté inférieur de la plaquette. Toutefois, un inconvénient de cette variante par rapport à l'exemple illustré aux figures 1a à 1h est que la gravure de la couche de parylène 13 du côté supérieur de la plaquette peut consommer une partie du masque de résine photosensible 14.

En référence aux figures 4a à 4i, un procédé de fabrication de composants horlogers selon un deuxième mode de réalisation de l'invention comprend une première étape consistant à se munir d'une plaquette 25 de type silicium sur isolant (en anglais : SOI ou Silicon On Insulator) comprenant une couche supérieure de silicium 26, une couche inférieure de silicium 27 et une couche intermédiaire de dioxyde de silicium 28 liant les deux couches de silicium 26, 27 (figure 4a).

Dans une deuxième étape du procédé (figure 4b), une couche de dioxyde de silicium 29 est formée au moins sur les surfaces supérieure et inférieure de la plaquette. La couche de dioxyde de silicium 29 peut être déposée sur la plaquette 25, par exemple par dépôt chimique ou physique en phase vapeur (CVD, PVD), ou peut être obtenue par oxydation thermique de la plaquette 25 dans un four à haute température (typiquement entre 800°C et 1200°C) sous atmosphère humide. Dans le cas de l'oxydation thermique, toutes les surfaces de la plaquette 25 sont couvertes par la couche de dioxyde de silicium 29.

Dans une troisième étape, on forme de manière classique un masque de résine photosensible 30 sur la surface supérieure de la plaquette 25, 29 obtenue à l'issue de la deuxième étape, par dépôt d'une couche de résine photosensible puis structuration de cette couche par photolithographie.

Dans une quatrième étape, la couche de dioxyde de silicium 29 du côté supérieur de la plaquette est gravée à travers les ouvertures du masque de résine photosensible 30, par exemple par gravure RIE. La couche de dioxyde de silicium 29 ainsi gravée constitue elle aussi un masque de gravure.

Une cinquième étape (figure 4c) consiste à graver la couche supérieure de silicium 26 à travers les ouvertures de la superposition des masques de résine photosensible 30 et de dioxyde de silicium 29 par gravure RIE, de préférence par gravure DRIE. La gravure de la couche supérieure de silicium 26 est arrêtée par la couche intermédiaire de dioxyde de silicium 28.

Dans une sixième étape, les éventuels résidus du masque de résine photosensible 30 sont éliminés, par exemple par décapage au plasma d'oxygène.

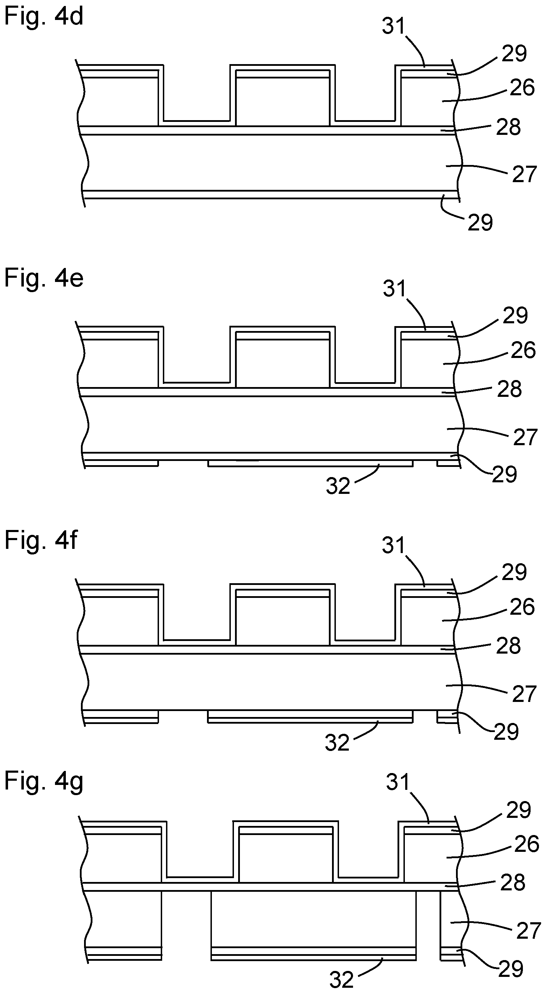

Une septième étape (figure 4d) consiste à former, par exemple par dépôt sous vide, une couche de parylène 31 sur la surface supérieure de la plaquette 26, 27, 28, 29 obtenue à la fin de la sixième étape. Pendant la formation de cette couche de parylène 31, la surface inférieure de la plaquette peut être protégée par un masque. De préférence, toutefois, la couche de parylène est formée de manière uniforme sur toutes les surfaces de la plaquette puis elle est retirée sur la surface inférieure, par exemple par gravure RIE.

Dans une huitième étape (figure 4e), un masque de résine photosensible 32 est formé sur la surface inférieure de la plaquette 26, 27, 28, 29, 31 issue de la septième étape par dépôt d'une couche de résine photosensible puis structuration de cette couche par photolithographie.

Dans une neuvième étape (figure 4f), la couche de dioxyde de silicium 29 du côté inférieur de la plaquette est gravée à travers les ouvertures du masque de résine photosensible 32, par exemple par gravure RIE. La couche de dioxyde de silicium 29 ainsi gravée constitue elle aussi un masque de gravure.

Dans une dixième étape (figure 4g), la couche inférieure de silicium 27 est gravée depuis le côté inférieur de la plaquette à travers les ouvertures de la superposition des masques de résine photosensible 32 et de dioxyde de silicium 29, par gravure RIE, de préférence par gravure DRIE. La gravure de la couche inférieure de silicium 27 est arrêtée par la couche intermédiaire de dioxyde de silicium 28.

Pour faciliter la mise en œuvre des huitième à dixième étapes et le travail depuis le côté inférieur de la plaquette, la plaquette peut être retournée avant la huitième étape.

Les couches de silicium 26, 27 gravées forment ensemble un squelette, des composants horlogers à deux niveaux (chaque couche de silicium 26, 27 définissant un niveau), des attaches ou ponts de matière reliant les composants horlogers au squelette (une ou plusieurs attaches par composant horloger, chaque attache pouvant être formée dans les deux couches de silicium 26, 27 ou dans une seule d'entre elles) et des parties sacrificielles (dans les deux couches de silicium ou dans une seule d'entre elles). Les parties sacrificielles sont situées à l'intérieur et/ou à l'extérieur des composants horlogers. Elles ne sont reliées ni au squelette ni aux composants horlogers dans les couches de silicium 26, 27 et ne sont donc tenues que par la couche intermédiaire de dioxyde de silicium 28 et la couche de parylène 31.

Les composants horlogers à deux niveaux sont par exemple des ancres d'échappement dont les palettes et la baguette sont formées uniquement dans la couche inférieure de silicium 27 et dont le dard, comme l'attache qui relie l'ancre au squelette, est formé uniquement dans la couche supérieure de silicium 26. Comme pour la roue d'échappement 15 illustrée à la figure 2, les parties sacrificielles à l'intérieur de chaque ancre et les rainures qui les entourent, ici formées typiquement dans les deux couches de silicium 26, 27, peuvent servir, une fois les parties sacrificielles enlevées, à former des évidements traversants dans l'ancre pour par exemple définir des bras élastiques permettant le montage de l'ancre sur un axe et/ou absorber des contraintes de déformation et/ou alléger l'ancre. Les parties sacrificielles à l'extérieur de chaque ancre et les rainures qui les entourent, elles aussi formées typiquement dans les deux couches de silicium 26, 27, peuvent servir à former ensemble un évidement traversant entourant l'ancre et la séparant donc du squelette, évidement que traversera l'attache.

Comme dans le premier mode de réalisation, la couche de parylène 31 garantit le maintien des parties sacrificielles dans la plaquette avec les composants horlogers et empêche notamment les parties sacrificielles de tomber dans la machine de gravure RIE/DRIE en faisant céder la couche intermédiaire de dioxyde de silicium 28 dans les zones (correspondant aux rainures délimitant les parties sacrificielles) où le silicium a été gravé des deux côtés.

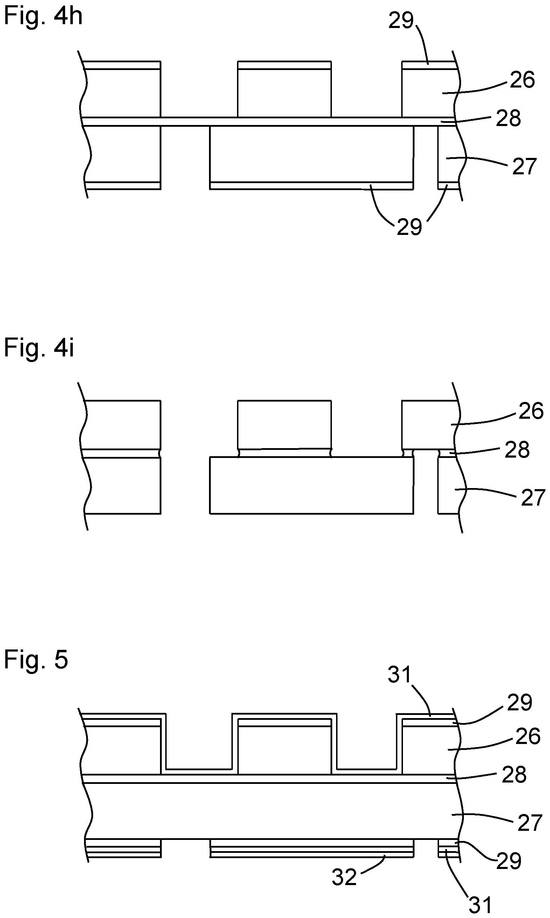

Dans une onzième étape du procédé (figure 4h), le masque de résine photosensible 32, la couche de parylène 31 et les couches de passivation de la gravure DRIE sont éliminés, par exemple par décapage au plasma d'oxygène.

Dans une douzième étape (figure 4i), le dioxyde de silicium des côtés supérieur et inférieur de la plaquette ainsi que le dioxyde de silicium exposé de la couche intermédiaire 28 (c'est-à-dire le dioxyde de silicium sans silicium d'un côté et/ou de l'autre), en particulier le dioxyde de silicium exposé à travers les rainures entourant les parties sacrificielles, sont éliminés par exemple par gravure chimique humide ou gravure chimique en phase vapeur, typiquement à l'acide fluorhydrique (HF). A la fin de cette étape, toutes les parties sacrificielles sont tombées.

Enfin, dans une treizième étape, les composants horlogers sont détachés du squelette par rupture ou élimination des attaches, par exemple au moyen d'un laser.

Selon une variante du deuxième mode de réalisation de l'invention, dans la septième étape, la couche de parylène 31 formée sur toutes les surfaces de la plaquette n'est pas retirée sur la surface inférieure de la plaquette. Ainsi, entre les huitième et neuvième étapes, la couche de parylène du côté inférieur de la plaquette est gravée, par exemple par gravure RIE, pour y former des ouvertures alignées avec les ouvertures du masque de résine photosensible 32. Le masque pour la gravure de la couche inférieure de silicium 27 à la dixième étape est alors constitué par la superposition des couches gravées de résine photosensible 32, de parylène 31 et de dioxyde de silicium 29, comme illustré à la figure 5. Laisser la couche de parylène 31 tout autour de la plaquette dans la septième étape supprime le risque que le solvant utilisé pour développer la résine photosensible dans la huitième étape s'introduise entre les couches de dioxyde de silicium 29 et de parylène 31 et provoque un décollement de la couche de parylène du côté supérieur de la plaquette.

Dans chacun des premier et deuxième modes de réalisation, entre l'étape d'élimination du dioxyde de silicium exposé et l'étape de rupture ou d'élimination des attaches, le procédé peut comprendre une ou plusieurs étapes d'oxydation-désoxydation et/ou une étape finale d'oxydation pour augmenter la résistance mécanique des composants horlogers et améliorer leur état de surface, comme décrit dans les demandes de brevet WO 2019/180596 et WO 2021/186332 du présent déposant.

Dans chacun des premier et deuxième modes de réalisation, l'étape de formation de la couche de dioxyde de silicium 12, 29 (deuxième étape) et donc aussi les étapes de gravure de cette couche (cinquième et huitième étapes du premier mode de réalisation et quatrième et neuvième étapes du deuxième mode de réalisation) pourraient être supprimées. Dans ce cas, dans le premier mode de réalisation, la couche de parylène 13 remplirait une deuxième fonction, à savoir servir de couche d'arrêt pour la gravure du silicium.

Selon un troisième mode de réalisation de l'invention, le procédé de fabrication de composants horlogers comprend les mêmes étapes que le premier mode de réalisation ou ses variantes mais les composants horlogers ou certains d'entre eux ne sont reliés au squelette par aucune attache dans la couche de silicium 11 à la fin de la gravure RIE/DRIE. Il s'agit de composants horlogers qui, par exemple pour des raisons esthétiques, ne peuvent présenter dans leur état final aucun résidu d'attache sur leur surface. Ces composants horlogers sont recueillis après la gravure RIE/DRIE, hors de la machine de gravure, de la même manière que les parties sacrificielles du premier mode de réalisation. Des parties sacrificielles peuvent aussi être gravées puis enlevées dans ce troisième mode de réalisation.

Enfin, selon un quatrième mode de réalisation de l'invention, le procédé de fabrication de composants horlogers comprend les mêmes étapes que le deuxième mode de réalisation ou ses variantes mais les composants horlogers ou certains d'entre eux ne sont reliés au squelette par aucune attache dans les couches de silicium 26, 27 à la fin des gravures RIE/DRIE. Il s'agit de composants horlogers qui, par exemple pour des raisons esthétiques, ne peuvent présenter dans leur état final aucun résidu d'attache sur leur surface. Ces composants horlogers sont recueillis après les gravures RIE/DRIE, hors de la machine de gravure, de la même manière que les parties sacrificielles du deuxième mode de réalisation. Des parties sacrificielles peuvent aussi être gravées puis enlevées dans ce quatrième mode de réalisation.

Les composants horlogers fabriqués selon le procédé selon l'invention sont par exemple des roues (par exemple des roues d'échappement), des plateaux (par exemple des plateaux de balanciers), des disques, des ancres, des aiguilles, des bascules, des leviers, des ressorts (par exemple des spiraux), des balanciers, des guidages flexibles et/ou des composants à guidages flexibles.

## Revendications

1. Procédé de fabrication de composants horlogers comprenant les étapes suivantes :
- se munir d'une plaquette (10) comprenant une couche de silicium (11),
- former une couche de parylène (13) au moins sur un premier côté de la plaquette,
- graver la couche de silicium (11) par gravure ionique réactive depuis un deuxième côté de la plaquette opposé au premier côté, de sorte à former dans la couche de silicium (11) un squelette (16), des composants horlogers (15), des attaches (17) reliant les composants horlogers (15) au squelette (16) et des parties sacrificielles (18, 19), les parties sacrificielles (18, 19) n'étant reliées ni au squelette (16) ni aux composants horlogers (15) dans la couche de silicium (11) gravée mais étant maintenues dans la plaquette par la couche de parylène (13),
- éliminer la couche de parylène (13),
- rompre ou éliminer les attaches (17).

2. Procédé selon la revendication 1, comprenant, entre l'étape consistant à se munir d'une plaquette (10) et l'étape consistant à former une couche de parylène (13), une étape consistant à former une couche de dioxyde de silicium (12) sur les premier et deuxième côtés de la plaquette (10), et dans lequel la couche de dioxyde de silicium (12) sur le deuxième côté de la plaquette est gravée à travers un masque (14) avant l'étape de gravure de la couche de silicium (11).

3. Procédé de fabrication de composants horlogers comprenant les étapes suivantes :
- se munir d'une plaquette (25) comprenant une première couche de silicium (26), une deuxième couche de silicium (27) et, entre les deux, une couche intermédiaire de dioxyde de silicium (28),
- graver la première couche de silicium (26) par gravure ionique réactive depuis un premier côté de la plaquette,
- après cette étape de gravure, former une couche de parylène (31) au moins sur le premier côté de la plaquette,
- graver la deuxième couche de silicium (27) par gravure ionique réactive depuis un deuxième côté de la plaquette opposé au premier côté, de sorte que les première et deuxième couches de silicium (26, 27) gravées comprennent ensemble un squelette, des composants horlogers, des attaches reliant les composants horlogers au squelette et des parties sacrificielles, les parties sacrificielles n'étant reliées ni au squelette ni aux composants horlogers dans les première et deuxième couches de silicium (26, 27) gravées mais étant maintenues dans la plaquette par la couche de parylène (31),
- éliminer la couche de parylène (31),
- éliminer les parties exposées de la couche intermédiaire de dioxyde de silicium (28),
- rompre ou éliminer les attaches.

4. Procédé selon la revendication 3, comprenant, entre l'étape consistant à se munir d'une plaquette (25) et l'étape consistant à graver la première couche de silicium (26), une étape consistant à former une couche de dioxyde de silicium (29) sur les premier et deuxième côtés de la plaquette (25) suivie d'une étape consistant à graver la couche de dioxyde de silicium (29) sur le premier côté de la plaquette à travers un masque (30), et comprenant, avant l'étape consistant à graver la deuxième couche de silicium (27), une étape consistant à graver la couche de dioxyde de silicium (29) sur le deuxième côté de la plaquette à travers un masque (32).

5. Procédé selon l'une quelconque des revendications 1 à 4, dans lequel les parties sacrificielles (18, 19) servent à former des évidements dans les composants horlogers (15) et/ou des évidements entourant les composants horlogers (15) pour séparer ces derniers du squelette (16).

6. Procédé de fabrication de composants horlogers comprenant les étapes suivantes :
- se munir d'une plaquette comprenant une couche de silicium,
- former une couche de parylène au moins sur un premier côté de la plaquette,
- graver la couche de silicium par gravure ionique réactive depuis un deuxième côté de la plaquette opposé au premier côté, de sorte à former dans la couche de silicium un squelette et des composants horlogers, les composants horlogers n'étant pas reliés au squelette dans la couche de silicium gravée mais étant maintenus dans la plaquette par la couche de parylène,
- éliminer la couche de parylène.

7. Procédé selon la revendication 6, comprenant, entre l'étape consistant à se munir d'une plaquette et l'étape consistant à former une couche de parylène, une étape consistant à former une couche de dioxyde de silicium sur les premier et deuxième côtés de la plaquette, et dans lequel la couche de dioxyde de silicium sur le deuxième côté de la plaquette est gravée à travers un masque avant l'étape de gravure de la couche de silicium.

8. Procédé de fabrication de composants horlogers comprenant les étapes suivantes :
- se munir d'une plaquette comprenant une première couche de silicium, une deuxième couche de silicium et, entre les deux, une couche intermédiaire de dioxyde de silicium,
- graver la première couche de silicium par gravure ionique réactive depuis un premier côté de la plaquette,
- après cette étape de gravure, former une couche de parylène au moins sur le premier côté de la plaquette,
- graver la deuxième couche de silicium par gravure ionique réactive depuis un deuxième côté de la plaquette opposé au premier côté, de sorte que les première et deuxième couches de silicium gravées comprennent ensemble un squelette et des composants horlogers, les composants horlogers n'étant pas reliés au squelette dans les première et deuxième couches de silicium gravées mais étant maintenus dans la plaquette par la couche de parylène,
- éliminer la couche de parylène,
- éliminer les parties exposées de la couche intermédiaire de dioxyde de silicium.

9. Procédé selon la revendication 8, comprenant, entre l'étape consistant à se munir d'une plaquette et l'étape consistant à graver la première couche de silicium, une étape consistant à former une couche de dioxyde de silicium sur les premier et deuxième côtés de la plaquette suivie d'une étape consistant à graver la couche de dioxyde de silicium sur le premier côté de la plaquette à travers un masque, et comprenant, avant l'étape consistant à graver la deuxième couche de silicium, une étape consistant à graver la couche de dioxyde de silicium sur le deuxième côté de la plaquette à travers un masque.

10. Procédé selon l'une quelconque des revendications 1 à 9, dans lequel la gravure ionique réactive est une gravure ionique réactive profonde.

11. Procédé selon l'une quelconque des revendications 1 à 10, dans lequel l'étape consistant à former la couche de parylène (13 ; 31) au moins sur le premier côté de la plaquette comprend le dépôt de la couche de parylène sur toutes les surfaces de la plaquette puis l'élimination de la couche de parylène sur le deuxième côté.

12. Procédé selon l'une quelconque des revendications 1 à 10, dans lequel l'étape consistant à former la couche de parylène (13 ; 31) au moins sur le premier côté de la plaquette consiste à déposer la couche de parylène sur toutes les surfaces de la plaquette, et dans lequel avant l'étape de gravure ionique réactive depuis le deuxième côté de la plaquette la couche de parylène (13 ; 31) sur le deuxième côté est gravée à travers un masque (14 ; 32).

13. Procédé selon l'une quelconque des revendications 1 à 12, dans lequel les composants horlogers comprennent au moins l'un des types suivants de composants : roues, plateaux, disques, ancres, aiguilles, bascules, leviers, ressorts, balanciers, guidages flexibles, composants à guidages flexibles.
